Europäisches Patentamt

European Patent Office

Office européen des brevets

(11) Publication number: **0 340 376**
**A1**

## (12) EUROPEAN PATENT APPLICATION

(21) Application number: **88830200.7**

(22) Date of filing: **09.05.88**

(51) Int. Cl.⁴: **H05K 3/40** , **H05K 3/28**

(30) Priority: **03.05.88 IT 1792488**

(43) Date of publication of application:
**08.11.89 Bulletin 89/45**

(84) Designated Contracting States:
**AT BE CH DE ES FR GB GR LI LU NL SE**

(71) Applicant: **CISEL - S.P.A.**
**Via della Stazione, 64-66**
**I-60022 Castelfidardo (AN)(IT)**

Applicant: **R.I.C.O. - S.R.L.**
**Via Adriatica, 17**
**I-60022 Castelfidardo (AN)(IT)**

(72) Inventor: **Saraceni, Maurizio**
**Via Vasari, 59**
**Osimo (AN)(IT)**
Inventor: **Saraceni, Luciano**
**Via Vasari, 59**
**Osimo (AN)(IT)**

(74) Representative: **Baldi, Claudio**
**Piazza Ghislieri, 3**
**I-60035 Jesi (Ancona)(IT)**

(54) **Electric circuit for electronic machines, printed by means of a silk-screen process onto a polyester film with a multi-layered structure.**

(57) A circuit board of which the main wires (2), which are conventionally printed, by silk screening on one side of a polyester film (1), are covered and protected by a second film of polyester (5) which also covers the holes (1a) made in the film (1) at the various intersection points at which the electric contact is made between the main and secondary wires (4), which are subsequently silk-printed on the other side of the film (1) and if necessary covered by a layer of protecting varnish (6).

FIG. 1

## Electric circuit board for electronic equipment, silk-printed on polyester multi-layer film.

This patent application for an industrial invention relates to an electric circuit board for electronic equipment which is printed on a flexible polyester or polyamide film or on any other type of material suited to this purpose. The electric circuit board has a new structure which not only better protects the electric wires against solvents, atmospheric agents, especially from humidity, but also ensures that the layer covering the wires is more resistant to scratching, flaking or cracking due to flexural stresses.

In order to demonstrate the characteristics of the printed circuit according to the invention more fully, a description will be given of how it is constructed and how a conventional electric circuit printed on a flexible film is made using current techniques.

The industrial production technique used today consists of firstly silk-printing the support film on to which all the main electric wires are traced using conduction ink, as for example silver or graphite ink.

Two layers of dielectric varnish must then be applied at predetermined points for particular wires at which these wires will be intersected by other wires which are subsequently traced over.

In other words, the layers of dielectric varnish must form an electric insulation bridge which permits a wire to cross another without forming short-circuit contacts at the nodes of the electric circuit meshes.

Once the dielectric varnish bridges have been formed, a second series of wires are silk-printed over the base wires. A layer of protecting varnish is then applied on the whole surface of the support film so as to cover all the main and secondary wires, except for short sections where the electric contact is made for activation.

It is clear from the above description that electric insulation between two intersecting wires is provided only by the bridge of dielectric varnish which unfortunately at times forms minute holes or cracks,which will obviously create unwanted short-circuit contacts which cause complete failure so that the electric circuit board will have to be scrapped either during production or replaced if it has been installed.

As far as the overall protection of the wires is concerned, this is provided only by the layer of varnish which is applied at the end of the production cycle over the support film.

The aim of this invention is to improve the reliability of current electric circuit boards printed on flexible films, both in terms of protection of the main wires and in terms of the consistency and resistance of the electric insulation bridges between intersecting wires.

To do this according to the invention, the secondary wires are traced on the support film on the other side of the support on which the main circuits are printed initially. To make the electric contact between these, holes are made on the support film at the intersection points at which these contacts must occur, so that the electric insulation at all the other nodes of the electric mesh is provided by the supporting film itself, which separates the series of wires traced on the opposite sides.

The industrial process used for manufacturing the electric circuit board according to the invention is as follows. After the main wires have been conventionally silk-printed, holes are made on the support film at the preset intersection points. The support film is then covered by a matching polyester film, so that the main wires traced on the support are enclosed and protected within two polyester films, or in any other similar material which is suited to this use.

When the secondary wires are silk-printed on the other side of the support film, the conductive inks penetrate and settle in the holes previously made on the print film, and are covered by the second protection film which is applied to the print film.

A layer of protective varnish should obviously be applied to the side of the latter,on which the secondary wires are traced, with exception of the short sections which are left uncovered since they provide the contact for activation when necessary.

Obviously for this reason the printed circuit board, according to the invention, will ensure electric insulation bridges between the intersecting wires which are more reliable with respect to current manufacturing techniques. The insulation on current printed circuit boards is provided by a double layer of dielectric varnish, while in the circuit in question the insulation is provided by the printed film placed between the main wires and the secondary wires, the two sets of wires being traced on the two sides of the film.

Note that the main wires on the circuit in question, which are usually the majority, are enclosed between the two films, i.e. the film on which the wires are traced and the film which is placed over the first to cover the holes made at the nodes of the electric mesh at which contact must be made between the intersecting wires.

It is evident that with respect to the protective varnish applied to the wires to date, this second film with which the main wires of the circuit are covered according to the invention, offers greater reliability in terms of mechanical resistance to scratching and tearing due to flexural stress.

The protection provided by the second film with respect to atmospheric agents, especially in the case of humidity, as well as in the case of ion migration, is also particularly effective.

For the sake of greater clarity the description of the invention continues with reference to the enclosed drawings. which are indicated only for illustrative (not not limiting) purposes and in which a section of the printed circuit according to the invention has been illustrated schematically, duly sectioned and enlarged to illustrate its "sandwich" structure clearly.

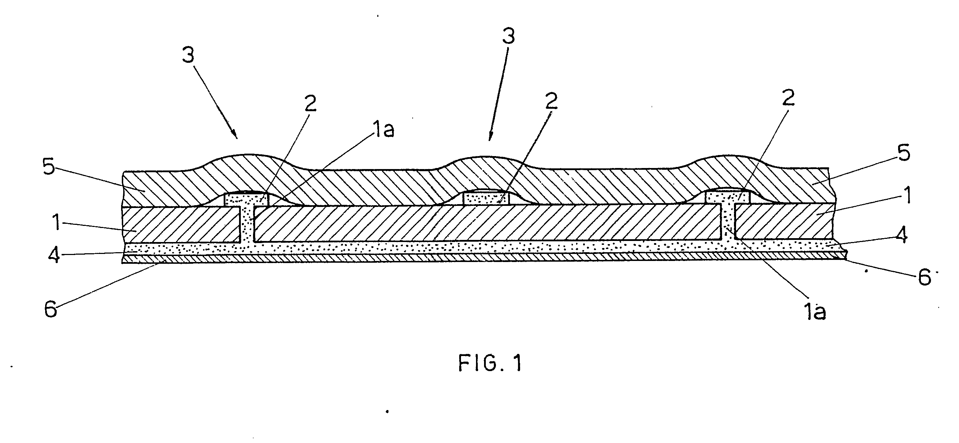

With reference to Fig. 1, it may be seen that the printed circuit according to the invention includes a polyester film (1), on one side of which the main wires (2) are printed with conventional silk-printing techniques using conductive ink.

According to the invention, after silk-printing holes are made on the film (1) and wires (2) at those intersection points (3) at which there is to be a contact between the main wires (2) previously traced and the secondary wires (4), which are to be traced in due course.

Once these holes have been made, the main wires (2) are covered with a polyester film (5), which covers the print film (1) exactly.

This film (5) acts both as a protection for all the main wires (2) and also covers the holes (1a) which have been made on some of the main wires (2) themselves.

After this film (5) has been applied, the secondary wires (4) are silk-printed on the other side of the film (1). Obviously during this printing phase, the tracing inks will penetrate and settle in the above-mentioned holes (1a), so as to ensure an electric contact between the wire (2) and the wire (4).

If it is necessary to protect the secondary wires (4), this is achieved by applying a layer of varnish (6) which represents the final stage in the manufacturing process of the printed electric circuit according to the invention.

(4) is to be made, the secondary wires being later silk-printed on the other side of the film (1) and, if necessary, covered by a layer of protective varnish (6).

## Claims

1) An electric printed circuit for electronic equipment silk-printed on polyester film with a multi-layer structure and characterized in that the main wires (2), which are printed using conventional techniques on one side of a polyester film (1), are covered and protected by a second polyester film (5), which also serves to cover the holes (1a) previously made on the film (1) at the points of intersection (3) at which the electric contact between the main wires (2) and the secondary wires

FIG. 1

EP 0 340 376 A1

TAV. 1-1

Dr. Ing. CLAUDIO BALEI
MANDATARIO ABILITATO

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | WO-A-8 200 938 (SERRAS-PAULET) <br> * Page 9, line 29 - page 11, line 15; figures 3-4 * <br> --- | 1 | H 05 K 3/40 <br> H 05 K 3/28 |
| A | FR-A-2 468 279 (EDITIONS EDMOND DUJARDIN) <br> * Page 2, lines 9-32; figures * <br> ----- | 1 | |
| | | | TECHNICAL FIELDS SEARCHED (Int. Cl.4) <br><br> H 05 K |

| | |
|---|---|
| The present search report has been drawn up for all claims | |

| Place of search | Date of completion of the search | Examiner |
|---|---|---|
| THE HAGUE | 27-07-1989 | SCHUERMANS N.F.G. |